# EUROPEAN PATENT SPECIFICATION

(11) **EP 4 052 372 B1**
(45) Date of publication and mention of the grant of the patent: **20.09.2023**
(21) Application number: 20825152.0
(22) Date of filing: 02.11.2020
(51) Int. Cl.: H03K 17/60, H03K 17/74

(54) **IMPROVEMENTS TO A CIRCUIT AND DEVICE INCLUDING A TRANSISTOR AND DIODE**
VERBESSERUNGEN AN EINER SCHALTUNG UND VORRICHTUNG MIT EINEM TRANSISTOR UND EINER DIODE
PERFECTIONNEMENTS APPORTÉS À UN CIRCUIT ET À UN DISPOSITIF COMPRENANT UN TRANSISTOR ET UNE DIODE

(30) Priority: 01.11.2019 GB 201915954
(43) Date of publication of application: 07.09.2022
(73) Proprietor: Search for the Next Ltd, Nottingham NG7 2TU (GB)
(72) Inventor: SUMMERLAND, David, Nottingham, Notinghamshire NG7 2TU (GB); KNIGHT, Luke, Nottingham, Notinghamshire NG7 2TU (GB); LIGHT, Roger, Nottingham, Notinghamshire NG7 2TU (GB)
(74) Representative: Tolfree, Adam Joseph Benjamin
(86) International application number: PCT/GB2020/000091
(87) International publication number: WO 2021/084216

(56) References cited:
- EP-A2- 0 430 063
- US-A- 4 668 875
- Tony R. Kuphaldt: "Lessons In Electric Circuits, Volume IV - Digital" In: "Lessons In Electric Circuits, Volume IV - Digital", 1 November 2007 (2007-11-01), XP055232715, pages 33-45

## Description

The use of a 'normally on' transistor, namely where the transistor functions in an ON state in the absence of a signal applied to the base is desirous for the formation of digital logic circuits as they allow for the construction of logic gates without need for complementary transistors, halving the transistor count.

It is known that a PNP bipolar junction transistor (BJT) can be operated as a normally on transistor through a circuit configuration in which the base of the BJT is connected to ground through a resistor. When a voltage is applied across the emitter and base terminals of the BJT, the emitter being more positive, a current can flow out of the base terminal and through the resistor. This allows for current flow between the emitter and collector terminals of the transistor, in other words the transistor is ON. To turn the transistor OFF, the base of the transistor is connected to a current source able to provide sufficient current through the resistor that the current through the transistor drops sufficiently (or stops) such that current flow between the emitter and collector ceases.

The temperature coefficient of resistors are typically large. This makes it difficult to provide the aforementioned circuit with operational stability over a wide range of temperatures. Further, the resistance value (ohms) of the resistor must be large to be sufficiently current limiting that the transistor can be switched off with the maximum current available from the current source. Resistors with values that meet this requirement are physically large. For these reasons it is impracticable to use this circuit design in many integrated circuits (IC).

Known circuits comprising transistors are disclosed in US4668875 and Tony R. Kuphaldt: "Lessons In Electric Circuits, Volume IV - Digital" In: "Lessons In Electric Circuits, Volume IV",

According to a first aspect of the invention there is provided a circuit according to claim 1.

According to another aspect of the invention there is provided a method of operating a circuit according to claim 10.

The following applies to either aspect of the invention.

The diode provides the current limiting function of a large resistor of the prior art circuit; however, the diode, unlike a resistor, is a relatively small electronic component and therefore makes the circuit more feasible for use in implementing digital logic circuits.

The current limiting function of the diode provides a convenient means to restrict current flow through the base-emitter terminals of the transistor when ON to allow for a relatively small potential drop across the emitter base of the transistor. This leads to a small change in the voltage at the base (relative to reference voltage) when the transistor switched between OFF and ON. This reduces parasitic effects between bases of neighbouring transistors formed within a semiconductor device.

The diode may provide the current limiting function in one or more ways. The physical size of the diode may be selected to provide the required resistance; the smaller the diode the more limited its current carrying capacity. Alternatively or additionally the diode may be arranged in the circuit to be reversed biased when the voltage is applied across and emitter terminal of the transistor and the second terminal of the diode. This latter method is preferred, especially where larger diodes are to be used.

The circuit may be operated such that the diode is reversed biased with a voltage across the diode that is below its breakdown voltage. When reverse biased, current flow through the diode may be a result of a leakage current, e.g. due to quantum tunnelling.

The diode may be a zener diode. Zener diodes, when biased below their zener voltage (breakdown voltage),operate reliably compared with other diodes. Nevertheless, alternative diodes may be used such as, for example, a tunnel diode which may be operated in forward bias.

Favourably the modulus of the temperature coefficient of the diode is less or equal to 2mV per degree Celsius. More favourably the diode has a temperature coefficient of approximately 0mV per degree Celsius as this provides the greatest degree of operational stability with changes in temperature.

To provide this temperature coefficient it is preferred that the diode is a zener diode selected to exhibit a zener voltage between 4 and 7 Volts inclusive, favourably less than or equal to about 5.6V, and more favourably about 5.6V.

The circuit finds particular utility for implementing a logic gate, for example as an inverter logic gate, that outputs a voltage representing the opposite logic level to an input connected to the base of the transistor. Multiple of the aforementioned circuits as variously described above, may be connected together to implement logic gates that perform other logical operations.

An increased voltage across the diode leads to increased current through the diode, increasing the switching speed of the transistor between an OFF and ON state. Where implemented in logic circuitry, an increased switching speed reduces the resolve time of the logic circuitry and thus increases the speed at which the logic circuitry can be clocked.

Increasing the voltage across the diode leads to an increased emitter-collector current through the transistor. This allows for a higher current signal source to the base of a next stage transistor of the logic circuitry enabling that the next stage transistor to switch faster as well.

However an increased voltage across the diode leads to an increase in the power consumed by the circuit. Through provision of the means (e.g. a switching speed controller) to vary and thus control the voltage across the diode it is possible to provide increased switching speed whilst minimising the increase in power consumption.

Varying the reference voltage may be achieved by a connection between the second terminal of the diode to a dynamic voltage source and/or by provision of a switching means arranged to switchably connect the second terminal of the diode to one of the multiple different reference voltage sources, each different reference voltage source providing a different reference voltage. One or more of the different reference voltage sources may be dynamic voltage sources.

The means to control the switching speed of the transistor may be arranged to receive a clock signal and adapted to use the clock signal to vary the voltage across the diode over time.

Favourably the means to control the switching speed (switching speed controller) of the transistor is arranged to vary the voltage across the diode during a period of the clock cycle such that the voltage across the diode is relatively high when the transistor is likely to be switching, e.g. towards the beginning of a clock cycle, and relatively low when it is likely to be static, typically at the end of the clock cycle.

This may be achieved, for example, by the means to control the switching speed of the transistor being arranged to switch connection of the second terminal of the diode between a high reference voltage source and a low reference voltage source at a frequency that corresponds to an integer multiple of the clock speed.

The bipolar junction transistor may be of PNP or NPN form. With PNP form the voltage across the emitter and second terminal of the diode is arranged such that conventional current flows from the emitter, through the transistor out of the base terminal and into the diode, and that the signal source is a current source. With the NPN form the voltage across the emitter and second terminal of the diode is arranged such that conventional current flows from the second terminal of the diode, through the diode, into the base terminal and out through the emitter, and that the signal source is a current sink.

The invention will now be described by way of example with reference to the following figures in which:
**Figure 1** is a schematic of a circuit comprising a PNP bipolar junction transistor and a reversed biased zener diode, which implements an inverter logic gate (NOT gate) the circuit including a switching means to vary the voltage seen at the anode of the diode;
**Figure 2** shows representations of timing sequences illustrating how the voltage seen by the anode of the diode is varied with a clock signal; and
**Figure 3** is a schematic of a variant circuit to Fig 1 in which the circuit includes a variable voltage source connected to the second terminal of the zener diode.

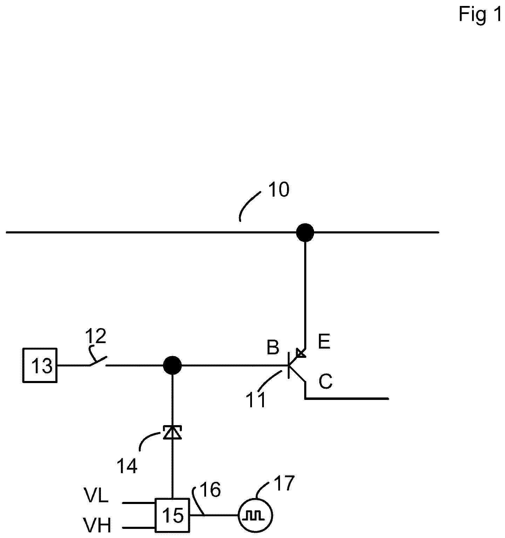

With reference to Figure 1 there is shown a circuit 10 comprising a PNP bipolar junction transistor 11. The emitter E of the transistor is connected to the high side rail and the collector of the transistor C connected to ground or some other low side voltage. The base B of the transistor 11 is switchably connectable through switch 12 to a current source 13.

A first terminal of a zener diode 14 is connected to both the base B of the transistor 11 and the current source 13 through switch 12. A second terminal of the diode 14 is connected selectively to one of two different low side reference voltages V_{L},V_{H} through switching circuitry 15.

V_{L} is a relatively low reference voltage and V_{H} a relatively high reference voltage compared with V_{L}. The two reference voltages may be provided by a number of voltage regulators. Both V_{L} and V_{H} are lower voltages than the high side reference voltage connected to the emitter.

The switching circuitry 15 receives a clock signal 16 from a clock 17. The switching circuitry 15 uses the clock signal to time the switching between the two reference voltages V_{L},V_{H} in a manner to be described later.

The zener diode 14 is oriented such as to be reverse biased. The zener diode 14 is chosen to have a zener voltage of about 5.6V in order that it has a temperature coefficient as close as possible to 0mV per degree Celsius. This ensures the zener diode's 14 characteristics remain stable with any change in the diode's 14 temperature, e.g. as a result of external conditions.

With switch 12 open, such that the current source 13 is isolated from the base terminal B, there is a voltage drop across the transistor 11 and diode 14, and hence conventional current flow through the emitter base terminals of the transistor 11 and through the reverse biased diode14; current flow through the diode 14 is attributable to a leakage current.

The circuit 10 is arranged such that, irrespective of whether the diode 14 is connected to V_{L} or V_{H}, the voltage drop across the diode 14 is below the breakdown voltage of the diode 14. The leakage current is thus thought to be a consequence of a quantum tunnelling effect within the diode 14.

The diode 14 is selected such that, for the expected voltages across it, sufficient leakage current flows through it and therefore also between the emitter E and base B of the diode to allow for current flow between the emitter E and collector C of the transistor 11; i.e. the transistor is ON.

Additionally, it is preferable that the diode 14 is selected that, for the expected voltage across it, the leakage current flow is kept as low as possible whilst ensuring the transistor is ON. This has the advantage of reducing the voltage drop across the transistor when the transistor is ON and therefore reduces the change in potential of the base of the transistor (relatively to ground of some reference voltage) when the transistor is switched between OFF and ON. This minimises static fields between transistors formed in the same wafer. In one example it is preferred that the switching voltage across the transistor is limited to around 0.5V.

When the switch 12 is closed the current source 13 is connected to the base terminal B of the transistor 11. The impedance of the current source 13 is selected to be lower than the impedance through the emitter base terminals of the transistor 11 causing the diode 14 to preferentially draw current from the current source 13 rather than the base B of the transistor 11. This results in current through the emitter-base of the transistor 11 reducing, e.g. substantially to zero, such that current between the emitter and collector reduces, if not ceases, to an extent that the transistor is considered OFF.

In order to ensure that current through the transistor 11 reduces when the switch 12 is closed, the diode 14 needs to be current limiting, i.e. it does not have the capacity to carry the maximum current that can be supplied by the current source 13 as well as the current from the transistor 11.

In the afore described circuit arrangement, the transistor 11 can be treated as operating as a normally on transistor as the transistor 11 is ON when there is no signal applied to the base.

The circuit of Figure 1 can be used to implement an inverter (NOT) logic gate. When the base is connected to a signal source (input ON), i.e. the current source 13, current flow at the collector side of the transistor 11 will be substantially zero (output OFF).

In contrast when the base is disconnected from the signal source (input OFF) there will be current through the collector (output ON).

Notwithstanding the above stated desire for leakage current to be kept as low as possible whilst ensuring the transistor is ON, an increased current flow through the diode 14 provides a faster switching speed of the transistor 11.

Increased current flow through the diode 14 is achieved by increasing the voltage across the diode 14 by altering the reference voltage seen by the second terminal of the diode 14. However, in addition to the drawback described above, increasing the current through the diode 14 also increases the power consumption of the circuit 10.

In the application of a logic gate, by altering the voltage that the second terminal of the diode 14 sees over time, such that there is a larger voltage across the diode 14 when the transistor 11 is expected to switch and a lower voltage across the diode 14 when the transistor 11 is expected not to be switching (static), it is possible to obtain the advantage of a fast switching speed whilst minimising the increase in power consumption of the circuit 10 compared with if the voltage across the diode was high all the time.

In the embodiment of Fig 1 this is achieved using the switching circuitry 15 to switch connection of the second terminal of the diode 14 between either V_{L}, where a larger voltage drop across diode 14 is desired, or V_{H} where a smaller voltage drop over diode 14 is desired.

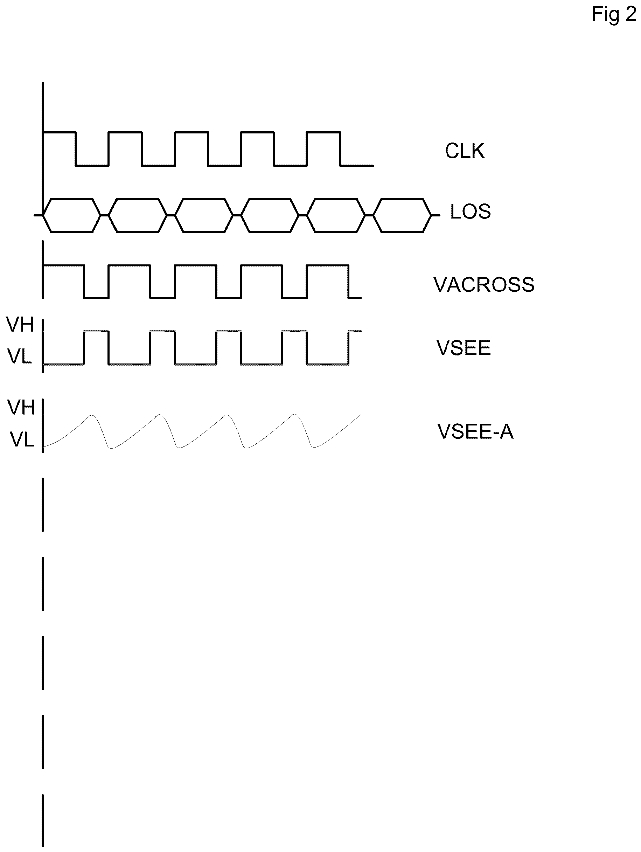

Figure 2 are timing diagrams illustrating how this may be implemented. The square wave line CLK represents the clock signal 16 used to coordinate actions of logic circuitry comprised from logic gates implemented using the transistor and diode arrangement of Figure 1. Immediately below the clock signal CLK is a representation of the logic state (LOS) of the logic circuitry during the clock cycles. Where LOS is composed of a single line the logic state of the circuitry is resolved, i.e. static; where the LOS is composed of two lines the logic state is unresolved as the circuit is settling. Ideally the circuit settles marginally before the end of a clock cycle so as to minimise the duration of the static state as far as possible.

Line V_{SEE} illustrates an example of how the reference voltage seen by the second terminals of the diodes 14 in the circuitry can be changed during a clock cycle in order to provide increased switching speed. V_{ACROSS} illustrates the corresponding change of voltage across the diodes 14.

At the beginning of a clock cycle the switching circuitry 15 operates to connect the second terminal to V_{L} such that the voltage across the diodes 14 increases. Whilst V_{ACROSS} is high, the transistors 11 in the logic circuitry associated with said diodes 14 switch faster leading to a shorter overall settling time of the logic circuitry compared with if V_{H} had remained high. Before the end of the clock cycle, the switching circuitry 15 operates to switch the second terminal to V_{H} such that the voltage across the diodes 14 drops; represented by V_{ACROSS} decreasing. Whilst V_{ACROSS} is low, the transistors 11 switch comparatively slower (if the switch is made before the circuit has settled), increasing the overall settling time of the circuitry, but reducing power consumption of the circuitry.

The duration that V_{ACROSS} remains high within a clock cycle can be set to provide a fine adjustment of the overall settling time of the circuit.

A coarser adjustment of the overall settling time is provided by selecting the magnitude in difference between V_{L} and V_{H}.

For the reasons discussed above, it is favourable that the value of V_{H} is selected such that when V_{H} is connected to the second terminal of diode 14, it results in the minimum leakage current though the diode 14 required to keep the transistor 11 ON.

The value of V_{L} is selected depending on the increase in switching speed desired compared with that obtained when V_{H} is connected.

These fine and course adjustments can be used to set up the logic circuitry to achieve a desired settling time, e.g. to match a clock speed that it is desired for the circuit to run at.

In this embodiment the clock cycle has a duty ratio of ~50%; this is not essential. Further, activation occurs on the rising edge of the clock signal; it will be appreciated that the falling edge or both edges could be used instead.

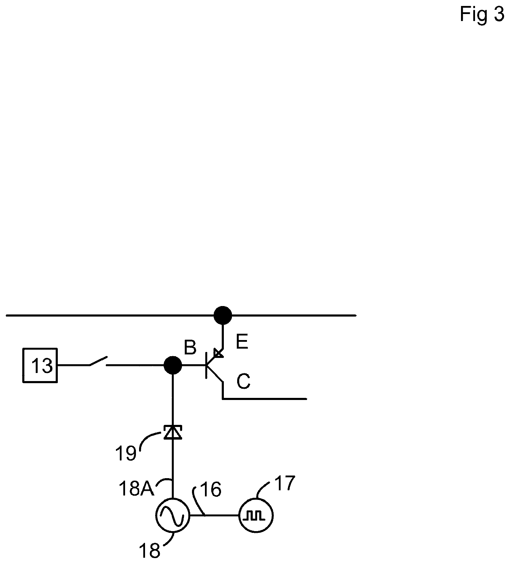

Figure 3 illustrates a variant circuit arrangement to Figure 1 in which the switching circuitry is replaced by a dynamic voltage source 18, for example an external voltage source, which is connected to the second terminal of the diode 14 about a terminal 18A. The dynamic voltage source 18 is arranged to receive the clock signal 16 and in response to vary the voltage at a terminal 18A over the period of a clock cycle.

Returning to Figure 2, V_{SEE-A} illustrates an example of an analogue voltage seen at the second terminal of the diode 14 as a result of its connection with the variable voltage source 18. As with V_{SEE}, the voltage is arranged to be low near the beginning of each cycle, when a fast switching speed is desired, and to rise towards the end of the cycle when the circuit is likely to be static. The form of the voltage curve over the cycle is asymmetric in order that the voltage across the diode is relatively high for a longer period of each cycle than it is relatively low. This can be reversed when a slower circuitry resolving time is desired.

Although the invention has been described in relation to digital logic circuits, it has broader application to any circuit including a transistor where there may be a benefit in increasing switching speed, for example an analogue multiplexer or analogue-digital converter (ADC) or digital-analogue converter.

For certain applications it may be preferable to control switching manually. In such cases the switching circuitry may be arranged to receive a user input signal, in addition or instead of a clock signal in order to alter the reference voltage connected to the second terminal of the diode.

The switching circuitry 15 may be arranged to switch between more than two reference voltages to provide more than one 'lower' voltage. One or more of the voltages V_{L} V_{H} may be dynamic voltages.

Figures 1 and 3 illustrate the current source 13 and switch 12 generically to ease understanding. In most practical implementations the base of the transistor will be connected to the output of another logic circuit(s) (earlier stage), with current ultimately derived from the high rail as opposed to an independent current source. Where so, the circuit is designed so that the impedance of the circuitry from the high rail to the base terminal is lower than the impedance between the emitter and the base of the transistor.

The use of a zener diode in a reverse biased arrangement with a voltage across it that is below its zener voltage is preferred because it provides operational stability, especially when the zener voltage is selected to minimise the diode's thermal coefficient. Nevertheless, other diode configurations are possible. For example where the diode is small enough and thus highly current limiting, it may be used in a normal biased arrangement. It is also possible that other type of diode be used, e.g. tunnel diodes. A tunnel diode may be used in a forward biased condition with the voltage across the diode being below the higher voltage that demarks the negative resistance region of the tunnel diode.

It will be appreciated that the circuits described above can similarly be implemented using NPN transistor. With the NPN form the voltage across the emitter and second terminal of the diode is arranged such that conventional current flows from the second terminal of the diode, through the diode, into the base terminal and out through the emitter, and that the signal source is a current sink. In such an arrangement V_{L} and V_{H} would be high side voltages, i.e. higher than the emitter side voltage of the NPN transistor, and the timing of switching there between reversed compared with that described above for a PNP transistor.

## Claims

1. A circuit (10) comprising:
a bipolar transistor (11); a signal source (13); and a switch (12);
a base terminal (B) of the bipolar transistor (11) being switchably connectable to the signal source (13) through the switch (12);
a diode (14) having a first terminal connected to the base terminal (B) of the transistor (11), and a second terminal connected to a first voltage;
the circuit (10) arranged, when in operation, such that when the signal source (13) is not connected to the base terminal (B) of the transistor (11), a second voltage applied at an emitter terminal (E) of the bipolar transistor (11) causes a current flow through the base terminal (B) of the transistor (11) and through the diode (14) such that the bipolar transistor (11) is in an ON state;
the impedance of the signal source (13) being lower than the impedance of the bipolar transistor (11) through the emitter and base terminals (E) (B);
the diode (14) selected to provide a current limiting function such that, during operation of the circuit, when the signal source (13) is connected to the base terminal (B) of the transistor (11), current flow through the base terminal (B) reduces such that the bipolar transistor (11)switches to an OFF state; and
means (15, 16, 17) to control the switching speed of the bipolar transistor (11), comprising means (15) to vary the first voltage to vary the voltage across the diode (14).

2. A circuit according to claim 1 comprising switching means arranged to switchably connect the second terminal of the diode to one of multiple different voltage sources, each voltage source providing a different voltage value.

3. A circuit according to claim 1 or 2 wherein the second terminal of the diode is connected to a dynamic voltage source.

4. A circuit according to any previous claim in which the means to control the switching speed of the bipolar transistor is arranged to receive a clock signal and adapted to use the clock signal to vary the voltage across the diode over time.

5. A circuit according to claim 4 in which the means to control the switching speed of the bipolar transistor is arranged such that the voltage across the diode is both relatively high for a period within each clock cycle and relatively low for period within each clock cycle.

6. A circuit according to claim 5 wherein the means to control the switching speed of the bipolar transistor is arranged such as to cause the voltage across the diode to vary within a clock cycle such as to be relatively high followed by being relatively low.

7. A circuit according to any previous claim wherein the diode is arranged in the circuit to be reversed biased when the second voltage is applied to the emitter terminal of the transistor.

8. A circuit according to any previous claim wherein the diode is a zener diode.

9. An inverter logic gate circuit comprising the circuit of any previous claim.

10. A method of operating a circuit (10);
the circuit (1) comprising a bipolar transistor (11), a diode (14) having a first terminal connected to the base terminal (B) of the bipolar transistor (11); and a second terminal of the diode (14) connected to a first voltage;
the method comprising: applying a second voltage across an emitter terminal of the bipolar transistor (11) and the second terminal of the diode (14);
switchably connecting the base terminal (B) of the bipolar transistor (11) and the first terminal of the diode (14) to a signal source (13) having an impedance lower than the impendence across the emitter and base terminals (E)(B) of the bipolar transistor (11) such that:
when not connected so as to cause a current flow through the base terminal (B) of the bipolar transistor (11) and through the diode (14) to turn the transistor ON;
and when connected current flow through the base terminal (B) of the bipolar transistor (11) reduces to switch the bipolar transistor (11) OFF; and
altering the switching speed of the bipolar transistor (11) by varying the second voltage.

11. A method according to claim 10 wherein the voltage across the diode is varied over time in response to a clock signal.

12. A method according to claim 11 in which the voltage across the diode is varied such as to be both relatively high for a period within each clock cycle and relatively low for period within each clock cycle.

13. A circuit according to claim 12 in which the voltage across the diode is varied within a clock cycle such as during the clock cycle it is relatively high followed by being relatively low.

14. A method according to any claim 10-13 wherein the second voltage is applied across the emitter terminal of the bipolar transistor and the second terminal of the diode such that the diode is reverse biased.

15. A method according to any claim 10-14 wherein the diode is a zener diode and the voltage applied across the diode when the transistor is ON is less than the zener diode's breakdown voltage.

## Patentansprüche

1. Ein Kreislauf (10) bestehend aus:
Einem bipolaren Transistor (11); einer Signalquelle (13); und einem Schalter (12);
einem Basisanschluss (B) des bipolaren Transistors (11), der sich über das Umschalten des Schalters (12) mit der Signalquelle verbinden lässt;
Einer Diode (14), deren Erstanschluss mit dem Basisanschluss (B) des Transistors (11) verbunden ist und ein Zweitanschluss zur ersten Spannung;
Ein Schaltkreis (10), der im Betrieb so angeordnet ist, dass bei Trennung der Signalquelle (13) vom Basisanschluss (B) des Transistors (11) eine zweite Spannung an einem Emitter-Anschluss (E) des bipolaren Transistors (11) dazu führt, dass durch den Basis-Anschluss (B) des Transistors (11) und durch die Diode (14) Strom fließt, sodass der bipolare Transistor (11) in einem ON-Zustand ist;
Die Impedanz der Signalquelle (13) niedriger ist als die Impedanz des bipolaren Transistors (11) durch den Emitter und die Basis-Anschlüsse (E) (B);
Die Diode (14), die zur Strombegrenzung dient, sodass beim Betrieb des Schaltkreises bei Anschluss der Signalquelle (13) an den Basis-Anschluss (B) des Transistors (11) der Stromfluss durch den Basisanschluss (B) reduziert ist, sodass der bipolare Transistor (11) in einen OFF-Zustand schaltet; und
Mittel (15, 16, 17), um die Schaltgeschwindigkeit des bipolaren Transistors (11) zu regeln, die Mittel (15) umfassen, um die Erstspannung zu variieren, um die Spannung an der Diode (14) zu variieren.

2. Ein Schaltkreis gemäß Anspruch 1, der aus einem Schaltmittel besteht, das so angeordnet ist, um den zweiten Diodenanschluss schaltbar an eine der vielen verschiedenen Spannungsquellen anzuschließen, wobei jede Spannungsquelle einen anderen Spannungswert liefert.

3. Ein Schaltkreis gemäß Anspruch 1 oder 2, wobei der Zweitanschluss der Diode an eine dynamische Spannungsquelle angeschlossen ist.

4. Ein Schaltkreis aus einem vorherigen Anspruch, wobei das Mittel zur Regelung der Schaltgeschwindigkeit des bipolaren Transistors so angeordnet ist, um ein Zeitsignal zu empfangen, und so angepasst ist, um anhand des Zeitsignals im Laufe der Zeit die Spannung an der Diode zu variieren.

5. Ein Schaltkreis gemäß Anspruch 4, wobei das Mittel zur Regelung der Schaltgeschwindigkeit des bipolaren Transistors auf eine Art und Weise angeordnet ist, dass die Spannung an der Diode für einen Zeitraum in jedem Zeitzyklus jeweils sowohl relativ hoch als auch relativ niedrig ist.

6. Ein Schaltkreis gemäß Anspruch 4, wobei das Mittel zur Regelung der Schaltgeschwindigkeit des bipolaren Transistors auf eine Art und Weise angeordnet ist, die dafür sorgt, dass die Spannung an der Diode innerhalb von einem Zeitzyklus so abweicht, dass sie relativ hoch gefolgt von relativ niedrig ist.

7. Ein Schaltkreis gemäß einem der vorherigen Ansprüche, wobei die Diode Schaltkreis so angeordnet ist, dass sie in Sperrrichtung gepolt wird, wenn die Zweitspannung an den Emitter-Anschluss des Transistors angelegt wird.

8. Ein Schaltkreis aus einem der vorherigen Ansprüche, wobei es sich bei der Diode um eine Zener-Diode handelt.

9. Ein Inverter-Logikgatter-Schaltkreis, der aus einem Schaltkreis aus einem der bisherigen Ansprüche besteht.

10. Eine Methode zum Betreiben eines Schaltrkreises (10);
Ein Schaltkreis (1) bestehend aus einem bipolaren Transistor, einer Diode (14), deren Erstanschluss mit dem Basisanschluss (B) des bipolaren Transistors (11) verbunden ist und ein Zweitanschluss der Diode (14) zur ersten Spannung;
wobei die Methode Folgendes umfasst: Anlegen einer Zweitspannung an einen Emitter-Anschluss des bipolaren
Transistors (11) und dem Zweitanschluss der Diode (14);
Schaltbarer Anschluss an den Basis-Anschluss (B) des bipolaren Transistors (11) und dem Erstanschluss der Diode (14) an eine Signalquelle (13), deren Impedanz niedriger ist als die Impedanz über den Emitter und die Basis-Anschlüsse (E) (B) des bipolaren Transistors (11), sodass gilt:
wenn nicht angeschlossen, um zu Stromfluss durch den Basis-Anschluss (B) des pipolaren Transistors (11) und durch die Diode (14) zu sorgen, um den Transistor auf ON zu schalten;
Und bei Anschluss wird der Stromfluss durch den Basis-Terminal (B) des bipolaren Transistors (11) reduziert, um den bipolaren Transistor (11) AUSzuschalten; und
Die Schaltgeschwindigkeit des bipolaren Transistors (11) wird durch Variieren der Zweitspannung geändert.

11. Eine Methode gemäß Anspruch 11, wobei die Spannung an der Diode im Laufe der Zeit als Reaktin auf ein Zeitsignal variiert wird.

12. Ein Methode gemäß Anspruch 11, wobei das Mittel zur Regelung der Schaltgeschwindigkeit des bipolaren Transistors auf eine Art und Weise variiert wird, dass die Spannung an der Diode für einen Zeitraum in jedem Zeitzyklus jeweils sowohl relativ hoch als auch relativ niedrig ist.

13. Ein Schaltkreis gemäß Anspruch 12, wobei die Spannung an der Diode im Zeitzyklus so variiert wird, dass sie im Zeitzyklus erst relativ hoch und anschließend relativ niedrig ist.

14. Eine Methode gemäß einem der Ansprüche 10 bis 13, wobei die Zweitspannung an den Emitter-Anschluss des bipolaren Transistors und den zweiten Terminal der Diode angeschlossen ist, damit die Diode umgepolt wird.

15. Eine Methode gemäß einem der Ansprüche 10 bis 14, wobei es sich bei der Diode um eine Zener-Diode handelt und die bei EINgeschaltetem Transisotr an die Diode angelegte Spannung niedriger als die Durchschlagsspannung der Zener-Diode ist.

## Revendications

1. Un circuit (10) comprenant :
un transistor bipolaire (11) ; une source de signal (13) ; et un commutateur (12) ;
une broche Base (B) du transistor bipolaire (11) pouvant être connectée de manière commutable à une source de signal (13) au moyen du commutateur (12) ;
une diode (14) ayant une première borne connectée à la broche Base (B) du transistor bipolaire (11), et une seconde borne connectée à une première tension ;
le circuit (10) est agencé, pendant le fonctionnement, de sorte que lorsque la source de signal (13) n'est pas connectée à la broche Base (B) du transistor bipolaire (11), une seconde tension appliquée à une broche Émetteur (E) du transistor bipolaire (11) provoque la circulation du courant à travers la broche Base (B) du transistor bipolaire (11) et à travers la diode (14) de sorte que le transistor bipolaire (11) est en état passant ;
l'impédance de la source de signal (13) étant inférieure à l'impédance du transistor bipolaire (11) à travers les broches Émetteur (E) et Base (B) ; et
la diode (14) sélectionnée pour assurer une fonction de limitation de courant de sorte que, durant le fonctionnement du circuit, lorsque la source de signal (13) est connectée à la broche Base (B) du transistor (11), la circulation du courant à travers la broche Base (B) diminue de telle sorte que le transistor bipolaire (11) passe à l'état bloqué ; et
des dispositifs (15, 16, 17) de contrôle de la vitesse de commutation du transistor bipolaire (11), comprenant le dispositif (15) pour faire varier la première tension qui entraîne la variation de la tension aux bornes de la diode (14).

2. Un circuit selon la revendication 1, comprenant un dispositif de commutation conçu pour assurer une connexion commutable de la seconde borne de la diode à l'une des différentes sources de tension, chaque source de tension fournissant une valeur de tension différente.

3. Un circuit selon la revendication 1 ou 2, dans lequel la seconde borne de la diode est connectée à une source de tension dynamique.

4. Un circuit selon l'une des revendications précédentes, dans lequel le dispositif de contrôle de la vitesse de commutation du transistor bipolaire est conçu pour recevoir un signal d'horloge et adaptés pour utiliser le signal d'horloge afin de faire varier la tension aux bornes de la diode dans le temps.

5. Un circuit selon la revendication 4, dans lequel le dispositif de contrôle de la vitesse de commutation du transistor bipolaire est agencé de sorte que la tension aux bornes de la diode soit à la fois relativement élevée pendant une période de chaque cycle d'horloge et relativement basse pendant une période de chaque cycle d'horloge.

6. Un circuit selon la revendication 5, dans lequel le dispositif de contrôle de la vitesse de commutation du transistor bipolaire est agencé de manière à faire varier la tension aux bornes de la diode pendant un cycle d'horloge de sorte qu'elle soit relativement élevée, puis relativement basse.

7. Un circuit selon l'une des revendications précédentes, dans lequel la diode est montée dans le circuit pour être polarisée en inverse lorsque la seconde tension est appliquée à la broche Émetteur (E) du transistor.

8. Un circuit selon l'une des revendications précédentes, dans lequel la diode est une diode Zener.

9. Un circuit de porte logique inverseur comprenant le circuit selon l'une des revendications précédentes.

10. Un procédé de fonctionnement d'un circuit (10) ;
le circuit (1) comprenant un transistor bipolaire (11) et une diode (14) ayant une première borne connectée à la broche Base (B) du transistor bipolaire (11) ; et une seconde borne de la diode (14) connectée à une première tension ;
le procédé comprenant : l'application d'une seconde tension à la broche Émetteur du transistor bipolaire (11) et à la seconde borne de la diode (14) ;
la connexion commutable de la broche Base (B) du transistor bipolaire (11) et de la première borne de la diode (14) à une source de signal (13) ayant une impédance inférieure à l'impédance aux broches Émetteur et Base du transistor bipolaire (11) de telle façon que :
lorsqu'elles ne sont pas connectées, cela provoque la circulation du courant à travers la broche Base (B) du transistor bipolaire (11) et aux bornes de la diode (14), pour faire passer le transistor en étant passant ;
et lorsqu'elles sont connectées, le courant circulant à travers la broche Base du transistor bipolaire (11) diminue, de sorte que le transistor passe en état bloqué ; et
modifiant la vitesse de commutation du transistor bipolaire (11) en faisant varier la seconde tension.

11. Un procédé selon la revendication 10, dans lequel la tension aux bornes de la diode varie dans le temps en réponse à un signal d'horloge.

12. Un procédé selon la revendication 11, dans lequel la tension aux bornes de la diode est modifiée de manière à être à la fois relativement élevée pendant une période de chaque cycle d'horloge et relativement basse pendant une période de chaque cycle d'horloge.

13. Un circuit selon la revendication 12, dans lequel la tension aux bornes de la diode est modifiée durant un cycle d'horloge de sorte que pendant le cycle d'horloge, elle est relativement élevée puis relativement basse.

14. Un procédé selon l'une des revendications 10 à 13, dans lequel la seconde tension est appliquée à la broche Émetteur du transistor bipolaire et à la seconde borne de la diode de sorte que la diode est polarisée en inverse.

15. Un procédé selon l'une des revendications 10 à 14, dans lequel la diode est une diode Zener et la tension appliquée aux bornes de la diode lorsque le transistor est en état passant est inférieure à la tension de claquage de la diode Zener.
